# EUROPEAN PATENT SPECIFICATION

(11) **EP 0 192 233 B1**
(45) Date of publication and mention of the grant of the patent: **19.04.1995**
(21) Application number: 86102055.0
(22) Date of filing: 18.02.1986
(51) Int. Cl.: C23C 18/16

(54) **Molded metallized articles and processes for making the same**
Metallisierte gegossene Gegenstände und Verfahren zu deren Herstellung
Procédé de préparation d'articles moulés métallisés et articles ainsi obtenus

(30) Priority: 22.02.1985 US 704440
(43) Date of publication of application: 27.08.1986
(73) Proprietor: AMP-AKZO CORPORATION (a Delaware corp.), Newark, Delaware 197113 (US); SMITH CORONA CORPORATION, New Canaan, CT 06840 (US)
(72) Inventor: Cleveland, Eric J., Homer, NY 13077 (US); Frisch, David C., Baldwin, NY 11510 (US); Weber, Wilhelm, Hicksville, NY 11801 (US)
(74) Representative: Königseder-Egerer, Claudia D.

(56) References cited:
- EP-A- 0 132 485
- GB-A- 1 254 308

## Description

This invention relates to molded one-piece articles having selected surface areas suitable for adherent metallization or molded metallized articles and processes for forming the articles. More particularly, this invention relates to molded, one-piece articles comprising an electric circuit pattern and processes for forming the said articles.

In US 3 629 185 there is described a process for forming a metallized article, such as a printed circuit board, having an insulating substrate as a base material. The process uses a plastic substrate filled with a powder catalyst which promotes metal deposition in a subsequent electroless metal plating step. The process also includes using a direct or reverse printing technique for preparing specific surface areas of the substrate to form the printed circuit for metallization. When high quantity production is needed, the printing step becomes costly.

US 4 402 135 describes a process for forming printed circuit boards which employs two separate injection molding steps to form a circuit pattern on a support board. In the first step, an electrically insulating plastic material for the substrate is injection molded. In the second step, an electrically conductive plastic material is injection molded. The electrically conductive plastic material is electroplated with metal to form electrically conductive paths.

A disadvantage of this method is that an excessive number of gates are required in the second cavity mold to fill several channels on the upper and lower surfaces, of the support member to provide a circuit pattern with several electrically conductive paths. Another disadvantage of this method is that the electrically conductive plastic strips may separate or peel off from the support member due to a lack of rigid connecting structure between the several plastic strips, particularly between the plastic strips on the upper and lower surfaces of the support member. When using a conductive plastic as in the cited prior art method, the circuit pattern cannot be molded with a web between conductors in the first molding step, or first shot, because all conductors would short circuit together.

In GB-A-1254308 it has been suggested to manufacture selectively metal-plated plastic parts by a two-shot injection or compression molding using a plateable and an unplateable plastics material. The arrangement of the mold and the order of the shots are such that those portions of the composite article which are to be plated are formed of the plateable plastics material. Subsequently, the article is subjected to the plating process.

The plateable plastics material is not catalytic for metal deposition per se, but is rendered catalytic by exposure of the molded article to a catalyzing solution.

It is an object of this invention to form a molded article for adherent metallization comprising an electric circuit pattern, such as a printed circuit network, by a process which eliminates the costly steps necessary to select surfaces for metallizing such as direct or reverse printing technique, litho-graphing, silk screening, and the like.

A further object of this invention is to form a molded article comprising an electric circuit pattern, by forming a first electrically insulating material into a first predetermined shape and by molding a second electrically insulating material into a second predetermined shape which includes interconnecting the second predetermined shape with the first predetermined shape to produce a one-piece article.

Another object of the invention is to form a molded article comprising an electric circuit pattern by an additive process using a minimum of steps.

A still further object of the invention is to form a molded article comprising an electric circuit pattern which has an additional integral molded structure.

A further object of this invention is to mold an article by an alternate two-shot injection molding press. The first shot of this alternate process forms a first predetermined shape of the article using a first electrically insulating material selected to avoid metal adherence. The second shot of this alternate process forms a second predetermined shape of the article using a second electrically insulating material catalyzed for metal adherence.

According to the invention, there is provided a process for producing a unitary non-conductive article comprising an electric circuit pattern, said process comprising the steps of molding a first insulating material into at least one first predetermined shape, said first material being catalytic for adherent metallization and capable to be catalyst-activated by an adhesion promotion catalyst activation process; molding a second electrically insulating material into at least one second predetermined shape, said second material being non-catalytic for adherent metallization and incapable to be catalyst-activated by the said adhesion promotion catalyst activation process; interconnecting said first and second shape to produce the unitary, one-piece, non-conductive article wherein selected surface areas of said article defined by exposed portions of the said first material are suitable for adherent metallization; exposing the surface of said article to the adhesion promotion catalyst activation process; and forming an adherent metal deposit on said exposed portions of said first insulating material.

Further according to the invention, there is provided a process for producing a unitary non-conductive article comprising an electric circuit pattern, said process comprising the steps of molding a first insulating material into at least one first predetermined shape, said first material being non-catalytic for adherent metallization and incapable to be catalyst-activated by an adhesion promotion catalyst activation process; molding a second electrically insulating material into at least one second predetermined shape, said second material being catalytic for adherent metallization and capable to be catalyst-activated by the said adhesion promotion catalyst activation process; interconnecting said first and second shape to produce the unitary, one-piece, non-conductive article wherein selected surface areas of said article defined by exposed portions of the said second material are suitable for adherent metallization; exposing the surface of said article to the adhesion promotion catalyst activation process; and forming an adherent metal deposit on said exposed portions of said second material.

According to the present invention there is further provided a molded unitary article comprising an electric circuit pattern, said article comprising at least a first predetermined shape comprised of a first electrically insulating material comprising a filler catalyst and capable to be catalyst activated by an adhesion promotion process causing catalyst activation; at least a second predetermined shape comprised of a second electrically insulating material, said material being free of a filler catalyst; said first and said second materials defining first and second patterns on a surface of the molded article, said first pattern being suitable for adherent metallization and said second pattern being resistant to adherent metallization; and a metal layer adhered to said first pattern with the second pattern completely free of metal deposit.

In the illustrated embodiment of this invention, there is shown a method for forming a molded article for adherent metallization, such as a printed circuit board, using a two-shot injection molding process. The process includes a first step of forming at least one first predetermined shape, such as a circuit pattern for a printed circuit board, by injection molding a first shot of electrically insulating material into a first mold cavity. The metal can be copper to form electrically conductive paths on a printed circuit board.

A second step is to remove the first predetermined shape from the first mold cavity and to insert it into a second mold cavity.

A third step is to form at least one second predetermined shape of the article, such as a support substrate for a printed circuit board, by injection molding a second shot of electrically insulating material into the second mold cavity. The second predetermined shape interconnects with the first predetermined shape to produce a molded one-piece article. The electrically insulating material selected for the second shot avoids metal adherence and performs as an electrically insulating material for a printed circuit board.

The article is then removed from the second mold cavity and processed by an additive process through a minimal series of steps to add metal only on exposed and thus selected surface areas of the first predetermined shape of the first shot injection molding.

Specific embodiments of the invention are described by way of examples with reference to the accompanying drawings in which: -
Figure 1 shows in perspective a portion of a first cavity mold forming a first Predetermined shape of an article, such as a circuit pattern, by a first shot injection molding process in accordance with the invention;
Figure 2 shows in perspective the circuit pattern removed from the first cavity mold;
Figure 3 shows in perspective a portion of a second cavity mold forming a second predetermined shape of an article, such as a support structure, by a second shot injection molding process onto the circuit pattern of Figure 2;
Figure 4 shows in perspective the support structure including the circuit pattern removed from the second cavity mold;
Figure 5 shows, similar to Figure 4, the step of adding a layer of copper to the exposed surfaces and holes formed by the first shot injection molding thereby forming the electrically conductive paths on the printed circuit board;
Figure 6 shows an alternative embodiment of Figure 4 with an additional structure integrally molded with the support structure of the second shot injection molding process.

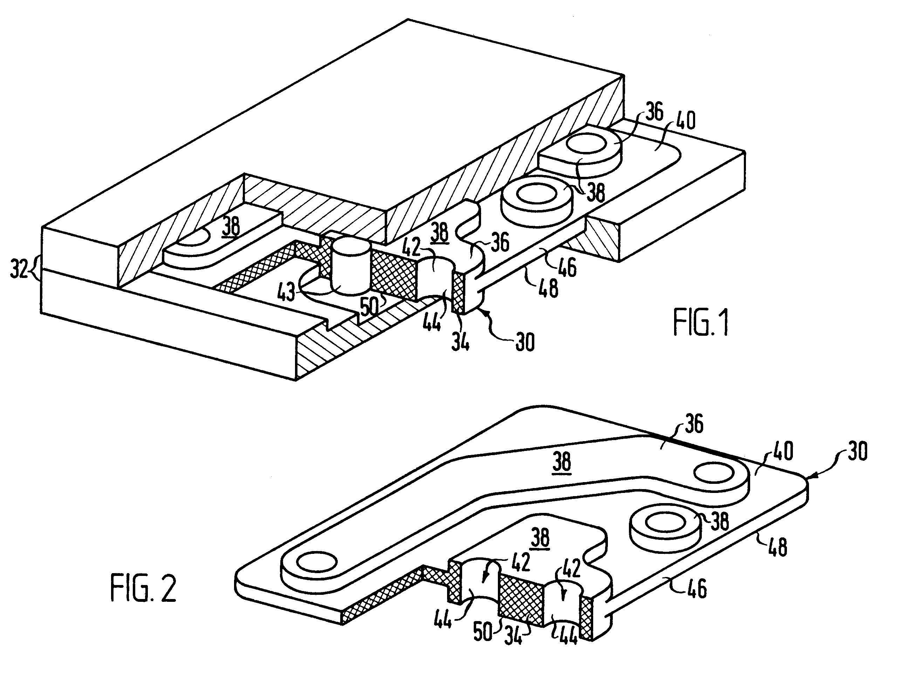

In Figure 1, a circuit pattern 30 is formed by a first shot injection molding process in a first mold cavity 32. A preferred first electrically insulating material 34 selected for this circuit pattern is polyethersulfone with a catalyst. A suitable polyethersulfone is Victrex® 4100 G, one suitable filler catalyst is a palladium catalyst dispersed on a powdered aluminum silicate clay as is disclosed in US Patent 3 600 330 by Examples 6 and 9. The catalyst mixed into the first electrically insulating material 34 catalyzes the material for electroless metal deposition in subsequent steps in the process. The electrically insulating material 34 can be treated by a minimal series of steps to add metal for forming electrically conductive paths 36 in a printed circuit board. Adhesion promotion of insulating materials containing the catalyst, herein also referred to as adhesion promotion catalyst activation process, activates the material for electroless metal deposition. Approximately 20% glass filler can be added to the electrically insulating material 34. However, the metal surfaces formed on the base material are smoother when using polyethersulfone without glass filler.

Other suitable electrically insulating materials for the circuit pattern 30 are ceramics, thermoset polymers and high temperature thermoplastic materials selected from a group consisting of polysulfone, polyethermimide, polyethersulfone, polyphenylene sulfide and polyetheretherketone.

Referring to Figure 2, the circuit pattern 30 has serveral full surface sections 38 on a first or component side 40.

Some of the full surface sections 38 have holes 42 which typically extend all the way through the thickness of the circuit pattern 30. The holes 42, formed by pins 43 (Fig. 1) have interior walls 44 for treatment to form electrically conductive paths 36 through the thickness of the circuit pattern 30. The circuit pattern 30 has a web portion 46 for connecting the full surface sections 38 to each other and for spacing the full surface sections 38 relative to each other. The web portion 46 is recessed below the full surface sections 38.

A second or solder side 48 of the circuit pattern 30 has several full surface sections 50 (only one shown). The web portion 46 connects the full surface sections 50 to each other and spaces the full surface sections 50 relative to each other. The circuit pattern 30 having the full surface sections 38, the full surface sections 50 and the web portion 46 fabricated by the first shot injection molding process forms a one-piece integral unit.

A feature of this invention is that the web portion 46 provides a rigid connecting structure between the full surface sections 38 on the component side 40 and the full surface sections 50 on the solder side 48 as well as between the several full surface sections 38 and 50 on each side of the circuit pattern.

Another feature of this invention is that the circuit pattern 30 with the web portion 46 can be used as both the circuit pattern and an insulating substrate by selective treatment of the circuit pattern 30 to form electrically conductive paths 36.

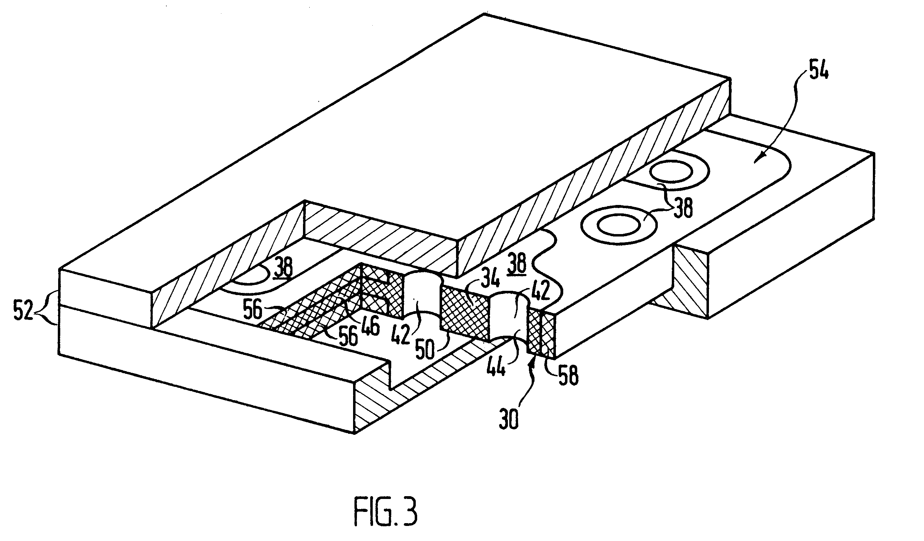

In Figure 3, the circuit pattern 30 has been removed from the first mold cavity 32 and inserted into a second mold cavity 52. A support structure 54 is formed by a second shot injection molding Process in the second mold cavity 52 and onto the molded circuit pattern 30. A preferred second electrically insulating material 56 selected for the support structure 54 is polyethersulfone (Victrex® 200P without catalyst). The electrically insulating material 56 may be with glass, mineral or other fillers. It is believed that it is preferable to use reinforcing fillers in this material to provide rigidity to the support structure 54. Other suitable materials for the second insulating material include ceramics, thermoset resins, and high temperature thermoplastic materials including polyesters.

The electrically insulating material 56 of the support structure 54 covers the web portion 46 on the component side 40 and on the solder side 48 of the circuit pattern 30 while leaving the full surface sections 38 and 50 exposed.

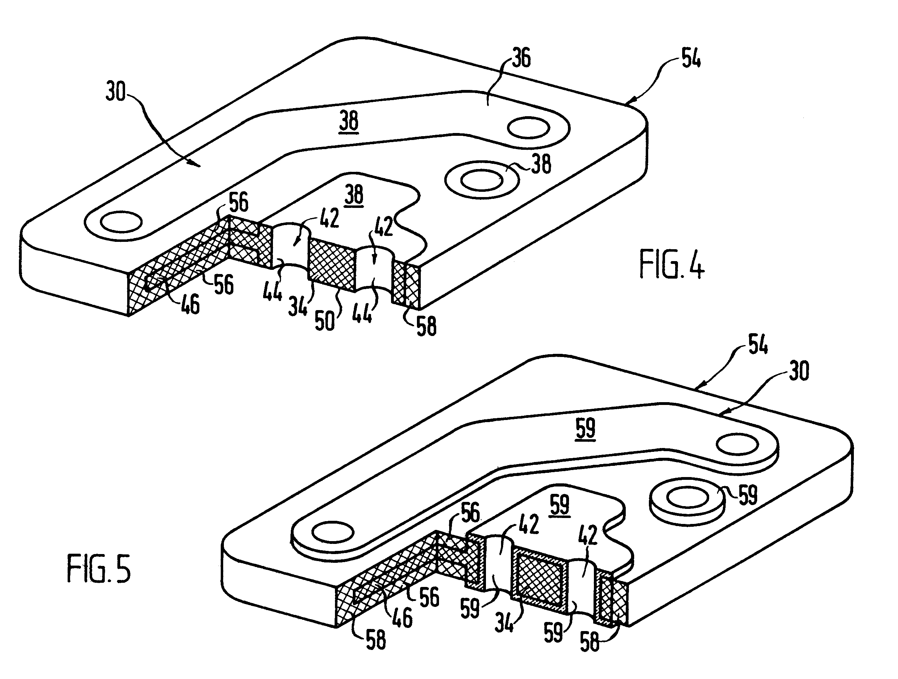

The electrically insulating material 56 of the support structure 54 is prevented from entering the holes 42 of the circuit pattern 30 by the second cavity mold 52. The electrically insulating material 56 also forms a border 58 around the periphery of the circuit pattern 30. The support structure 54 with the circuit pattern 30 is removed from the second cavity mold 52 and is ready for further processing (Figure 4).

Another feature of the invention is that the support structure 54 is rigidly connected to the circuit pattern 30 by covering the web portion 46 on the component side 40 and the solder side 48 and by forming a border 58 around the periphery of the circuit pattern 30.

In Figure 4, an alternate method of the invention is forming the support structure 54 by a first shot injection molding process in a first mold cavity and forming the circuit pattern 30 by a second shot injection molding process in a second mold cavity while maintaining the rigid connection structure between the circuit pattern 30 and the support structure 54. Preferably, the second shot would comprise more than one molded shape.

A layer of metal 59, such as copper, is adhered to the circuit pattern 30 as shown in Figure 5 to form electrically conductive paths 36 by subsequent steps in the process.

Since the first material 34 is capable of adherent metallization and the second material 56 is incapable of being adherently metallized, the metal 59 adheres only to the circuit pattern 30 formed from the first material 34.

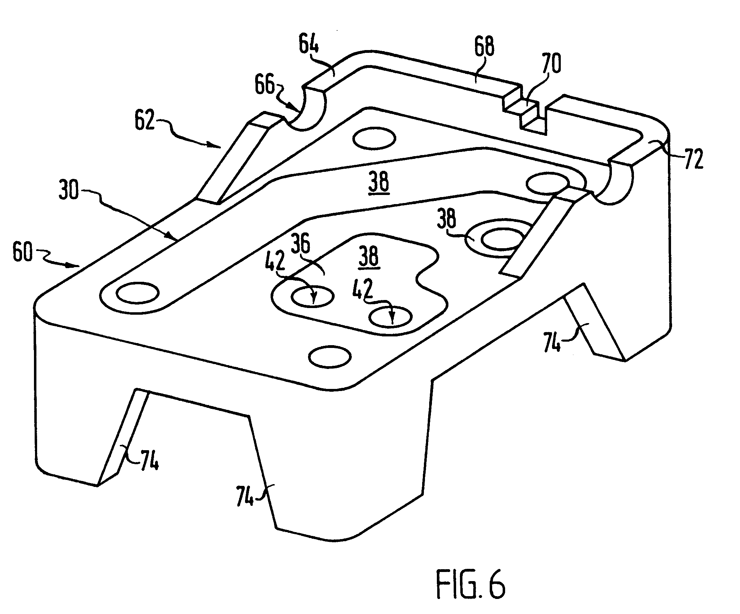

In Figure 6, another embodiment of the invention is a support structure 60. The support structure 54 of Figure 4 has a rigid flat structure which is typical for printed circuit boards. The support structure 60 has three-dimensional additional integrally molded structure 62 for mounting non-electrical components such as shafts, brackets, and the like, or for use as spacers, stand-offs, and the like. The structure 62 is molded from the electrically insulating plastic material 56. The molded structure 62 avoids costly secondary operations such as attaching independently made brackets, frames, and the like, to provide the same result. The structure 62 has a first upstanding wall 64 with a circular recess 66 therein for supporting a non-electrical component such as a cylindrical shaft. A second upstanding wall 68 has varying sized notches 70 for supporting rectangularly shaped components. A third upstanding wall 72 is similar to the first upstanding wall 64. Several legs 74 extend downward from the circuit pattern 30. The legs 74 can be used as spacers for spacing the circuit pattern 30 from other structures in any machine or apparatus. The upstanding walls 64, 68 and 72 and the legs 74 are examples of varying structures which can be integrally molded with the second shot injection molding process to reduce or avoid the cost of secondary operations such as adding independently made support brackets, frames, and the like.

The support structure 60 can be treated by the same process as the support structure 54 to form the electrically conductive paths 36.

Even though the molding process described is injection molding, the circuit pattern 30, the support structure 54, the first shape 82 and the second shape 104 can also be formed by compression, casting and other molding processes.

The selected first plastic material 43 and the second plastic material 56 are thermoplastics. Other materials could be used by this invention such as thermoset resins, ceramics, glass, and the like.

To add the metal 59 to the circuit pattern 30 (Fig. 5) for forming electrically conductive paths 36, a few process steps are taken, as described in the following examples.

### EXAMPLE 1

The circuit pattern 30 was molded with polyethersulfone resin (Victrex® P200) containing 15% of a palladium treated clay filler. The clay filler contains 0.1% palladium by weight. The support structure 54 was molded with clear polyethersulfone resin without filler.

The molded article was stress relieved by placing it in an oven; raising the oven temperature to 205°C; holding the article at that temperature for four hours; and then cooling the article in the oven.

After the article was stress relieved, it was adhesion promoted by the following procedure:

### Adhesion Promotion:

1. Immerse for 1 minute in a solution of 90% dimethylformamide and 10% water.
2. Immerse for 1 minute in an aqueous 0.4 g/l solution of Gafac® RE610 at 60°C.
3. Immerse for 1 minute in an aqueous solution of 48% sulfuric acid at 60°C.
4. Etch for 2 minutes at 60°C in an aqueous solution containing

| | |
|---|---|
| chromium trioxide | 400 g/l |
| sulfuric acid | 450 g/l |
| Perfluoroalkysulfonate | 0.5 g/l |

5. Rinse in a dragout rinse.
6. Neutralize the residual chromium by immersion for 5 minutes in a solution of 1.8% sulfuric acid and 1.4% hydrogen peroxide.
7. Repeat step 6 in another neutralizing solution of the same composition.
8. Rinse in water for 2 minutes.

The adhesion promotion process made the surface of the article microporous and hydrophilic, and exposed the catalyst on the surface sections 38 and 50 and the hole walls 44 of the circuit pattern 30. All the surfaces of the article, which were smooth and shiny before adhesion promotion, assumed a matte appearance. The surfaces 38, 50 and 44 were activated for electroless metal deposition.

### Adherent Metallization:

The molded article was immersed in an electroless copper plating solution for 1 hour to deposit a layer of copper 3 »m thick on the surface sections 38 and 50 and hole walls 44. The article was then rinsed; dried at 65°C for 30 minutes; immersed in dichloromethane vapors over boiling dichloromethane liquid; and dried again at 60°C for 30 minutes. In this process, the matte, hydrophilic surface of support structure 54 is made smooth, hydrophobic and resistant to extraneous metal deposition.

The molded article was then cleaned in a hot alkaline soak cleaner, rinsed, deoxidized in dilute sulfuric acid and returned to the electroless copper plating solution to deposit 25 »m of metal 59, such as copper, on the surface sections 38 and 50 and on the hole walls 44 thus completing the adherent metallization step to form the electrically conductive paths 36.

### EXAMPLE 2

The procedures of Example 1 are repeated using electroless nickel plating instead of electroless copper plating.

It can now be easily understood that the method for molding an article for adherent metallization formed from electrically insulating materials, such as a printed circuit board, has been significantly simplified by the present invention. Forming a circuit pattern 30 by a first shot injection molding process and interconnecting a support structure 54 or substrate to the circuit pattern 30 by using a second shot injection molding process to electrically insulate the circuit pattern 30, except for selected surface areas 38 and 50 being left exposed, reduces the number of steps required to treat the exposed surfaces 38 and 50 to form electrically conductive paths 36. This simplified method is particularly advantageous when producing these articles in high quantities.

This simplified method is further advantageous by being capable of integrally molding additional structures with the second shot injection molding process for mounting or attaching to non-electrical components.

## Claims

1. A process for producing a unitary non-conductive article comprising an electric circuit pattern, said process comprising the steps of molding a first insulating material into at least one first predetermined shape, said first material comprising a filler catalyst for adherent metallization and capable to be catalyst-activated by an adhesion promotion catalyst activation process; molding a second electrically insulating material into at least one second predetermined shape, said second material being non-catalytic for adherent metallization and incapable to be catalyst-activated by the said adhesion promotion catalyst activation process; interconnecting said first and second shape to produce the unitary, one-piece, non-conductive article wherein selected surface areas of said article defined by exposed portions of the said first material are suitable for adherent metallization; exposing the surface of said article to the adhesion promotion catalyst activation process; and forming an adherent metal deposit on said exposed portions of said first insulating material.

2. A process for producing a unitary non-conductive article comprising an electric circuit pattern, said process comprising the steps of molding a first insulating material into at least one first predetermined shape, said first material being non-catalytic for adherent metallization and incapable to be catalyst-activated by an adhesion promotion catalyst activation process; molding a second electrically insulating material into at least one second predetermined shape, said second material comprising a filler catalyst for adherent metallization and capable to be catalyst-activated by the said adhesion promotion catalyst activation process; interconnecting said first and second shape to produce the unitary, one-piece, non-conductive article wherein selected surface areas of said article defined by exposed portions of the said second material are suitable for adherent metallization; exposing the surface of said article to the adhesion promotion catalyst activation process; and forming an adherent metal deposit on said exposed portions of said second material.

3. The process of claim 1 or 2 wherein the molding process is injection molding.

4. The process of claims 1 to 3 wherein said first and second materials are selected form the group consisting of thermoplastic polymers, thermoset plastics, and ceramic materials.

5. The process of claim 4 wherein the thermoplastic polymers are selected from polyesters, polyetheretherketones, polyetherimides, polyethersulfones, polyphenylene sulfides and polysulfones.

6. The process of claims 1 to 5 wherein said catalytic material comprises a palladium catalyst.

7. The process of claim 6 wherein said palladium catalyst is dispersed in a filler consisting of powdered aluminum silicate clay.

8. A molded unitary article comprising an electric circuit pattern, said article comprising at least a first predetermined shape comprised of a first electrically insulating material comprising a filler catalyst and capable to be catalyst activated by an adhesion promotion process causing catalyst activation; at least a second predetermined shape comprised of a second electrically insulating material, said material being free of a filler catalyst; said first and said second materials defining first and second patterns on a surface of the molded article, said first pattern being suitable for adherent metallization and said second pattern being resistant to adherent metallization; and a metal layer adhered to said first pattern with the second pattern completely free of metal deposit.

9. The article of claim 8 wherein said filler catalyst comprises powdered aluminum silicate clay having dispersed in it a palladium catalyst.

10. The article of claim 8 or 9 wherein said first and second material comprise high temperature thermoplastic polymers.

11. The article of claim 10 wherein the high temperature thermoplastic polymers are selected from polyesters, polysulfones, polyetherimides, polyethersulfones, polyphenylene sulfides, and polyetheretherketones.

12. The article of one or more of claims 8 to 11 wherein said second material has been molded onto said first material.

13. The article of one or more of claims 8 to 11 wherein said first material has been molded onto said second material.

14. The article of claim 8 wherein the second shape molded onto the first shape is defining on the surface of the molded article the preselected insulating pattern outlining the conductive circuit pattern of an electric conductor network.

## Patentansprüche

1. Ein Verfahren zum Herstellen eines einheitlichen, nicht leitfähigen Gegenstandes mit einem elektrischen Schaltungsmuster, das die folgenden Schritte aufweist: Gießen eines ersten isolierenden Materials in wenigstens eine erste vorbestimmmte Form, wobei das genannte erste Material einen katalytischen Füllstoff für die festhaftende Metallisierung enthält und katalytisch aktiviert werden kann mittels eines Adhäsionspromotions-Verfahrens zur katalytischen Aktivierung; Gießen eines zweiten isolierenden Materials in wenigstens eine zweite vorbestimmte Form, wobei das genannte zweite Material nicht katalytisch für die festhaftende Metallisierung ist und nicht mittels des genannten Adhäsionspromotions-Verfahrens zur katalytischen Aktivierung katalytisch aktiviert werden kann; Verbinden der ersten und zweiten Form zum Herstellen des einheitlichen, aus einem Stück bestehenden, nicht leitfähigen Gegenstandes, der durch freiliegende Bezirke des genannten ersten Materials definierte ausgewählte Oberflächenbezirke aufweist, die für die festhaftende Metallisierung geeignet sind; Behandeln der Oberfläche des genannten Gegenstandes mit dem Adhäsionspromotions-Verfahren zur katalytischen Aktivierung; und Ausbilden eines festhaftenden Metallniederschlags auf den genannten freiliegenden Bezirken des genannten ersten isolierenden Materials.

2. Ein Verfahren zum Herstellen eines einheitlichen, nicht leitfähigen Gegenstandes mit einem elektrischen Schaltungsmuster, das die folgenden Schritte aufweist: Gießen eines ersten isolierenden Materials in wenigstens eine erste vorbestimmmte Form, wobei das genannte erste Material nicht katalytisch für die festhaftende Metallisierung ist und nicht mittels eines Adhäsionspromotions-Verfahrens zur katalytischen Aktivierung katalytisch aktiviert werden kann; Gießen eines zweiten isolierenden Materials in wenigstens eine zweite vorbestimmte Form, wobei das genannte zweite Material einen katalytischen Füllstoff für die festhaftende Metallisierung enthält und mittels des genannten Adhäsionspromotions-Verfahrens zur katalytischen Aktivierung katalytisch aktiviert werden kann; Verbinden der ersten und zweiten Form zum Herstellen des einheitlichen, aus einem Stück bestehenden, nicht leitfähigen Gegenstandes, der durch freiliegende Bezirke des genannten zweiten Materials definierte ausgewählte Oberflächenbezirke aufweist, die für die festhaftende Metallisierung geeignet sind; Behandeln der Oberfläche des genannten Gegenstands mit dem Adhäsionspromotions-Verfahren zur katalytischen Aktivierung; und Ausbilden eines festhaftenden Metallniederschlags auf den genannten freiliegenden Bezirken des genannten zweiten isolierenden Materials.

3. Das Verfahren nach Anspruch 1 oder 2, in dem das Gießverfahren ein Spritzgußverfahren ist.

4. Das Verfahren nach den Ansprüchen 1 bis 3, in dem die genannten ersten und zweiten Materialien aus der Gruppe bestehend aus thermoplastischen Polymeren, wärmeaushärtbaren Kunststoffen und keramischen Materialien ausgewählt sind.

5. Das Verfahren nach Anspruch 4, in dem die thermoplastischen Polyemere ausgewält sind aus Polyestern, Polyetheretherketonen, Polyetherimiden, Polyethersulfonen, Polyphenylensulfiden und Polysulfonen.

6. Das Verfahren nach den Ansprüchen 1 bis 5, in dem das genannte katalytische Material katalytisches Palladium enthält.

7. Das Verfahren nach Anspruch 6, in dem das genannte katalytische Palladium in einem Füllstoff verteilt ist, der aus gepulvertem Aluminiumsilikat-Ton besteht.

8. Ein im Gießverfahren hergestellter einheitlicher Gegenstand mit einem elektrischen Schaltungsmuster, der wenigstens eine erste vorbestimmte Form enthält, die aus einem ersten, einen katalytischen Füllstoff enthaltenden elektrisch isolierenden Material besteht, das durch ein Adhäsionspromotioms-Verfahren zur katalytischen Aktivierung katalytisch aktiviert werden kann; und wenigstens eine zweite vorbestimmte Form, die aus einem zweiten elektrisch isolierenden Material besteht, das keinen katalytischen Füllstoff enthält; das genannte erste und das genannte zweite Material erste und zweite Muster auf einer Oberfläche des im Gießverfahren hergestellten Gegenstandes definieren, wobei das genannte erste Muster für die festhaftende Metallisierung geeignet ist und das genannte zweite gegen die festhaftende Metallisierung resistent ist; und eine festhaftende Metallschicht das genannte erste Muster bedeckt, während das genannte zweite Muster keinen Metallniederschlag aufweist.

9. Der Gegenstand nach Anspruch 8, in dem der genannte katalytische Füllstoff aus gepulvertem Aluminiumsilikat-Ton mit in diesem fein verteiltem katalytischem Palladium besteht.

10. Der Gegenstand nach Anspruch 8 oder 9, in dem das genannte erste und zweite Material aus Hochtemperatur-beständigen thermoplastischen Polymeren besteht.

11. Der Gegenstand nach Anspruch 10, in dem die Hochtemperatur-beständigen thermoplastischen Polymere ausgewählt sind aus Polyestern, Polysulfonen, Polyetherimiden, Polyethersulfonen, Polyphenylensulfiden und Polyetheretherketonen.

12. Der Gegenstand nach einem oder mehreren der Ansprüche 8 bis 11, in dem das genannte zweite Material auf das genannte erste Material aufgegossen ist.

13. Der Gegenstand nach einem oder mehrenen der Ansprüche 8 bis 11, in dem das genannte erste Material auf das genannte zweite Material aufgegossen ist.

14. Der Gegenstand nach Anspruch 8, in dem die auf die erste Form aufgebrachte zweite Form auf der Oberfläche des im Gießverfahren hergestellten Gegenstandes das zuvor vorbestimmte Isolierstoffmuster definiert und so das elektrische Leitermuster einer elektrischen Schaltung bildet.

## Revendications

1. Procédé pour la préparation d'un article unitaire non-conducteur comprenant un schéma de circuit électrique, ledit procédé comprenant les étapes de moulage d'une première matière isolante en au moins une première forme pré-déterminée, ladite première matière comprenant une charge catalytique pour la métallisation adhérente et étant capable d'être activée catalytiquement par un procédé d'activation du catalyseur favorisant l'adhésion ; le moulage d'une deuxième matière électro-isolante en au moins une deuxième forme pré-déterminée, ladite deuxième matière étant non-catalytique pour la métallisation adhérente et incapable d'être activée catalytiquement par ledit procédé d'activation de catalyseur favorisant l'adhésion ; l'interconnexion de ladite première et deuxième forme pour produire l'article unitaire en une pièce non-conducteur, où les aires de surface choisies dudit article définies par des portions exposées de ladite première matière sont appropriées pour la métallisation adhérente ; l'exposition de la surface dudit article au procédé d'activation de catalyseur favorisant l'adhésion ; et la formation d'un dépôt de métal adhérent sur lesdites portions exposées de ladite première matière isolante.

2. Procédé pour la production d'un article unitaire non conducteur comprenant un schéma de circuit électrique, ledit procédé comprenant les étapes de moulage d'une première matière isolante en au moins une première forme prédéterminée, ladite première matière étant non-catalytique pour la métallisation adhérente et incapable d'être activée catalytiquement par un procédé d'activation de catalyseur favorisant l'adhésion ; le moulage d'une deuxième matière électro-isolante en au moins une deuxième forme prédéterminée, ladite deuxième matière comprenant une charge catalytique et étant capable d'être activée catalytiquement par un procédé d'activation de catalyseur favorisant l'adhésion ; l'interconnexion de ladite première et deuxième forme pour la préparation d'un article unitaire en une pièce non-conducteur où les aires de surface choisies dudit article définies par les portions exposées de ladite deuxième matière sont appropriées pour la métallisation adhérente ; l'exposition de la surface dudit article aux procédé d'activation de catalyseur favorisant l'adhésion ; et la formation d'un dépôt de métal adhérent sur lesdites portions exposées de ladite deuxième matière.

3. Procédé selon la revendication 1 ou 2, où le procédé de moulage est le moulage par injection.

4. Procédé selon les revendications 1 à 3, où lesdites première et deuxième matière sont prises dans le groupe comprenant les polymères thermoplastiques, les plasticle thermodurcis et les matières céramiques.

5. Procédé selon la revendication 4, où les polymères thermoplastiques sont pris dans le groupe comprenant les Polyesters, les polyéthercétones, les polyétherimides, les polyéthersulfones, les sulfures de polyphéylène et les polysulfones.

6. Procédé selon les revendications 1 à 5, où ladite matière catalytique comprend un catalyseur au palladium.

7. Procédé selon la revendication 6, où ledit catalyseur au palladium est dispersé dans une charge constituée d'argile de silicate d'aluminium pulvérulent.

8. Article unitaire moulé comprenant un schéma de circuit électrique, ledit article costitué d'au moins une première forme prédéterminée comprenant une première matière électro-isolante contenant une charge catalytique et capable d'être activée catalytiquement par un procédé favorisant l'adhésion provoquant l'activation de catalyseur ; au moins une deuxième forme prédéterminée constitué d'une deuxième matière électro-isolante, ladite latière étant dépourvue d'une charge catalytique ; ladite première et ladite deuxième matière définissant le premier et le deuxième schéma sur la surface de l'article moulé, ledit premier schéma étant approprié pour la métallisation adhérente et ledit deuxième schéma étant résistant à la métallisation adhérente ; et une couche de métal adhérant audit premier schéma avec le deuxième schéma entièrement dépourvu de dépôt de métal.

9. Article selon la revendication 8, où ladite charge catalytique comprend une argicle de silicate d'aluminium pulvérulente contenant le catalyseur au palladium dispersé.

10. Article selon la revendication 8 ou 9, où ladite première et deuxième matière comprend des polymères thermoplastiques hautes températures.

11. Article de la revendication 10, où les polymères thermoplastiques hautes températures sont choisis parmi les polyesters, les polysulfones, les polyétherimides, les polyéthersulfones, les sulfures de polyphénylène et les polyéthercétones.

12. Article selon une ou plusieurs des revendications 8 à 11, où ladite deuxième matière a été moulée sur ladite première matière.

13. Article selon l'une ou plusieurs des revendications 8 à 11, où ladite première matière a été moulée sur ladite deuxième matière.

14. Article selon la revendication 8, où la deuxième forme moulée sur la première forme moulée définit sur la surface de l'article moulé le schéma isolant présélectionné délimitant les schéma du circuit conducteur d'un réseau électro-conducteur.
